# EUROPEAN PATENT SPECIFICATION

(11) **EP 3 964 848 B1**
(45) Date of publication and mention of the grant of the patent: **07.08.2024**
(21) Application number: 21192378.4
(22) Date of filing: 20.08.2021
(51) Int. Cl.: G01R 31/327

(54) **CONTACT ARRANGEMENT HAVING A MEASURING DEVICE FOR DETERMINING A CONTACTING STATE OF THE CONTACT ARRANGEMENT BY MEANS OF AN ACOUSTIC SIGNAL**
KONTAKTANORDNUNG, DIE EINE MESSVORRICHTUNG ZUM BESTIMMEN EINES KONTAKTZUSTANDS DER KONTAKTANORDNUNG MITTELS EINES AKUSTISCHEN SIGNALS AUFWEIST
AGENCEMENT DE CONTACT DOTÉ D'UN DISPOSITIF DE MESURE POUR LA DÉTERMINATION D'UN ÉTAT DE CONTACT DE L'AGENCEMENT DE CONTACT AU MOYEN D'UN SIGNAL ACOUSTIQUE

(30) Priority: 24.08.2020 DE 102020122065
(43) Date of publication of application: 09.03.2022
(73) Proprietor: TE Connectivity Germany GmbH, 64625 Bensheim (DE)
(72) Inventor: KIPP, Stefan, 64625 Bensheim (DE)
(74) Representative: Grünecker Patent- und Rechtsanwälte PartG mbB

(56) References cited:
- US-A- 5 629 864
- US-A1- 2005 237 064
- US-A1- 2013 342 292
- US-A1- 2014 191 767
- US-A1- 2016 153 847
- US-A1- 2020 194 191
- ULTRAN GROUP: "Ultrasonic Transducers", 31 December 2018 (2018-12-31), pages 1 - 32, XP055881928, Retrieved from the Internet <URL:http://ultrangroup.com/wp-content/uploads/transducer-catalog.pdf>

## Description

The invention relates to a contact arrangement having a measuring device and to a method for measuring a contacting state, in particular a contact arrangement for the high-voltage and/or high-current range.

Such contact arrangements have two contacts which are electrically conductively connected to each other in a closed position and electrically isolated from each other in an isolated position. The contact arrangements can comprise a detector which allows to determine whether the contacts are isolated or closed. In this case, the contacting state is only measured indirectly via the position of an actuating element. However, this means that a state of failure in which, for example, one of the contacts is welded to the contact bridge cannot be detected or falsely declared as open or closed. Consequently, such contact arrangements are unsafe. Detectors registering changes in the electric and/or magnetic field are mostly also dependent on the level and type of the switched voltage and therefore cannot be used arbitrarily for different contact arrangements.

Prior art document US2020/194191 discloses an acoustic transducer that emits an acoustic wave toward a switch assembly, where it is reflected back to a receiver sensor, to measure displacement, the sensors operating in a non-contact manner. US5629864 and US2014/191767 sense the acoustic signature of circuit breakers in order to assess their state of health, operating without injection of acoustic signals into the breakers. US2013/342292 uses an ultrasonic sensor inside of the armature of a relay to sense the displacement.

The object of the invention is to provide a solution which can detect the contacting state of two contacts more reliably and in a versatile manner.

According to the invention, this is solved by a contact arrangement having a measuring device for detecting a contacting state of the contact arrangement and having at least two electrical contacts which are electrically isolated from one another in a first, open, contacting state and are electrically connected to one another in a second, closed, contacting state. The measuring device comprises an acoustic signal generator, which is adapted to couple an acoustic signal, in particular a sound wave, into a first of the at least two contacts, and a signal receiver, which is connected to a second of the at least two contacts in a sound-conducting manner.

In a method according to the invention for measuring a contacting state of a contact arrangement having at least two contacts, this is solved by coupling an acoustic signal into a first contact of the at least two contacts and receiving the acoustic signal at a second contact of the at least two contacts.

The invention further relates to a computer-implemented method comprising, according to the invention, the following steps:
- reading out a measurement signal from a measuring device, the measurement signal being representative of an acoustic signal transmitted from one contact of a contact arrangement to another contact of the contact arrangement, wherein the measurement signal includes at least one measurement parameter representative of at least one of the following parameters of the acoustic signal:
   - running time;
   - sound pressure;
   - sound energy; and
   - sound intensity;
- determining a contacting state of the contact arrangement based on the at least one measurement parameter.

By the solution according to the invention, it is ensured that the contacting state is measured directly via the contacts. The acoustic signal is conducted by means of structure-borne sound via the contacts of the contact arrangement from the signal transmitter to the signal receiver. Because the signal transmitter couples the acoustic signal into one contact and the signal receiver receives the signal at another contact, a measurement based on transmission takes place. In contrast to an indirect measurement based on reflection, in which the signal transmitter and signal receiver are arranged on the same contact and the reflection of the acoustic signal is registered on an actuating element, a higher level of safety is ensured. In the reflective measurement of the position of the actuating element for moving one contact relative to the other contact, for example, welding of the contacts cannot be detected, because the actuating element remains unaffected by the welding. Since the acoustic signal, in contrast to a magnetic or electrical signal, is independent of the type and level of voltage, failures caused, for example, by light bridges, short circuits and/or welding can be reliably detected. Furthermore, the measuring device and the method can be applied to different contact devices without undue effort.

The solution according to the invention can be further improved with the following further developments and configurations, each of which is advantageous in itself and can be arbitrarily combined with one another.

In a first preferred configuration, signal transmitters and/or signal receivers can be directly connected to the respective contacts. This allows the acoustic signal to be coupled directly into the contact or to be received by the contact without greatly influencing the parameters of the acoustic signal, which can further simplify the evaluation or provision of the measurement signal. Preferably, however, signal transmitter and/or signal receiver can be indirectly connected to the respective contact via at least one electrical isolator, in particular a galvanic isolator, such as a ceramic plate. Consequently, a short circuit can be prevented by a contact between the electrical components of the signal transmitter and/or signal receiver and the respective electrical contact.

The electrical isolator can be made of a material that has a similar, in particular the same, sound conduction as the material of the respective contact. The sound conduction depends on the density, transverse contraction coefficient, elastic modulus and shear modulus of the material. By selecting a suitable material of the electrical isolator, fluctuations in the parameters of the sound wave, in particular of the structure-borne sound, are avoided at the transitions between the isolator and the contact.

The signal transmitter and/or signal receiver can be adapted in particular to couple or receive an acoustic signal in the ultrasonic range, in particular from 16 kHz. Since an ultrasonic wave lies above the range audible to humans, undesirable noise pollution can thus be prevented by the measuring device.

The signal transmitter and/or signal receiver can in particular be a piezoelectric element, which can provide high precision and reliability over large measuring ranges. Furthermore, these piezoelectric elements are long-term stable and compact.

In a preferred configuration, the device, in particular the measuring device, can be adapted to output a measurement signal representative of at least one of the following parameters: running time; sound pressure; sound energy; and sound intensity.

A measurement signal that is representative of the sound intensity can be particularly advantageous in order to obtain the most accurate possible measurement of the contacting state with low vulnerability to error. Thus, in particular in the case of an ultrasonic wave, the presence of an air path or a layer of dirt leads to an attenuation of the sound intensity. Consequently, it is possible to detect a distance between the contacts or a contact inhibiting layer occurring between contacts which are in contact with each other.

If the measurement signal is to be representative of the propagation time of the sound wave from the signal transmitter to the signal receiver, the zero crossing, i.e. the phase change, of the sound wave can be considered as a reference point for the running time. Compared to the remaining sound parameters of the sound wave, the zero crossing of the sound wave is not influenced or at least less influenced by disturbances, e.g. sound reflection, transmission, absorption and dissipation. Therefore, when considering the duration required for the sound wave to travel from the signal transmitter to the signal receiver via the at least two contacts, a very accurate measurement signal can be output. This accuracy not only allows a conclusion to be drawn about the contacting state of the contact arrangement, but also about the distance between two contacts which are adapted to be in abutment against each other.

In a further preferred configuration, the measuring device can be adapted to output a measurement signal representative of the running time of the sound wave and a measurement signal representative of the sound intensity. The measurement signal representative of the sound intensity can be used to generate an output value representative of the contacting state with little effort, which can also be used to implement a circuit, for example. If a more precise analysis of the distance is required, an output value can be generated via the measurement signal representative of the running time of the sound wave.

The measurement can preferably take place continuously so that failures can be registered at any time. In particular, this enables the detection of the onset of levitation, i.e. the brief isolation of the contacts due to a short circuit, which can result in an electric arc with a high voltage. This signals that the contact arrangement should be replaced to ensure safe operation.

As an alternative to continuous measurement, the measurement can also be done at time intervals, in particular at uniform time intervals. For example, the signal transmitter can couple the acoustic signal into the first of the at least two contacts as a function of a switching signal. By avoiding continuous operation, the wear of the measuring device can be reduced. In a computer-implemented method, a command unit can be provided for this purpose, for example, via which the switching signal can be controlled.

The contact arrangement may comprise two contacts that are movable relative to each other. Thus, for example, the contact arrangement can be a switching arrangement, as in a relay. The contacts may comprise contacting ends with which they abut against each other in the closed contacting state. For example, one contact can be held stationary in the contact arrangement and the other contact can be movable. The movable contact can be moved, for example, by an actuator.

According to a further preferred configuration, more than two contacts can also be provided in the contact arrangement. For example, the contact arrangement can comprise three contacts, wherein one contact can be adapted as a bridge contact which is movable relative to the two other contacts, or at least one of them, and via which the two other contacts are electrically connected to each other in the closed contacting state. Consequently, the structure-borne sound is conducted from one contact to the other contact via the bridge contact.

If more than two contacts are provided in the contact arrangement, it is preferred if the signal transmitter is connected to a contact arranged at the first position in a switching row of the contact arrangement in a sound-conducting manner and the signal receiver is connected to a contact arranged at the last position in the switching row in a sound-conducting manner. Consequently, the acoustic signal can be conducted directly from the signal transmitter to the signal receiver via all contacts present in the switching row.

The contact arranged in the first position and the contact arranged in the last position can both be held stationary in the contact arrangement. The intermediate contacts can be movable relative to the two stationary contacts and serve as bridging contacts.

Preferably, all contacts of the switching row can be formed from the same material, or at least have approximately the same sound conduction, which can facilitate the evaluation of the measurement signal, since the characteristics of the propagation of the structure-borne sound remain essentially constant over the entire switching row.

An electrically isolating damping element can be arranged between the at least two contacts so that a structure-borne sound can be conducted from the first of the at least two contacts to the second of the at least two contacts via the damping element even in the isolated state. Thus, an acoustic signal can be recorded by the signal receiver even in the completely isolated state, allowing a measurement signal representative of a parameter, for example, the sound intensity, to be determined, which can correspond to a reference signal for the open contacting state. This reference signal can be used to ensure that the measuring device is functioning properly.

The damping element can preferably have a lower sound conductivity than the at least two contacts so that at least in the closed contacting state the structure-borne sound conducted via the contacts overlaps the structure-borne sound conducted via the damping element. The structure-borne sound conducted via the damping element can also be used, for example, to calibrate the measuring device.

In a further preferred configuration, the damping element can be realized as a carrier in which the at least two contacts are rigidly fixed. The damping element can be a housing wall, for example.

The at least two contacts can each comprise a contacting end which is adapted to abut against a further contact at least in the closed position and thus to establish an electrical connection. In order to conduct the acoustic signal in a directed manner over the entire contact, it is preferred if the signal transmitter and/or signal receiver is connected to the respective contact at an end of the contact facing away from the contacting end.

The measurement signal can be evaluated in the computer-implemented method, for example. For this purpose, an evaluation unit can be provided which uses the measurement signal to determine an output value representative of the contacting state and/or the distance between the contacts to be contacted, in particular the contacts to be contacted directly. Preferably, an output unit can be provided which outputs the output value determined by the evaluation unit.

Preferably, a system for data processing may be provided comprising a processor, in particular a signal processor, configured to execute the computer-implemented method.

A computer-readable storage medium may store instructions which, when executed by a computer, cause the computer to execute the computer-implemented method.

The computer-implemented method can in particular be executed continuously during operation, and the evaluation unit can be connected to the signal transmitter and/or signal receiver. Alternatively, a storage unit can be provided on which the measurement signal or even its course can be stored. This storage unit can be read out if required, for example, by means of a readout unit coupled to the evaluation unit.

Further, the use of a measuring device as described in the above may be applied to a contact arrangement comprising at least two contacts.

In the following, the invention is explained in more detail by means of preferred configurations with reference to the drawings. The preferred further developments and configurations shown are independent of each other and can be combined with each other as required in an application case.

It is shown by:
- Fig. 1: a schematic front view of an exemplary configuration of a contact arrangement according to the invention in a first, open contacting state;
- Fig. 2: a schematic front view of the exemplary configuration of Fig. 1 in a second, closed contacting state;
- Fig. 3: a schematic sketch of a block diagram of an exemplary configuration of a contact arrangement according to the invention;
- Fig. 4: a schematic sketch of the course of the sound intensity with increasing distance between the contacts to be contacted; and
- Fig. 5: a schematic sketch of the course of the running time with increasing distance between the contacts to be contacted.

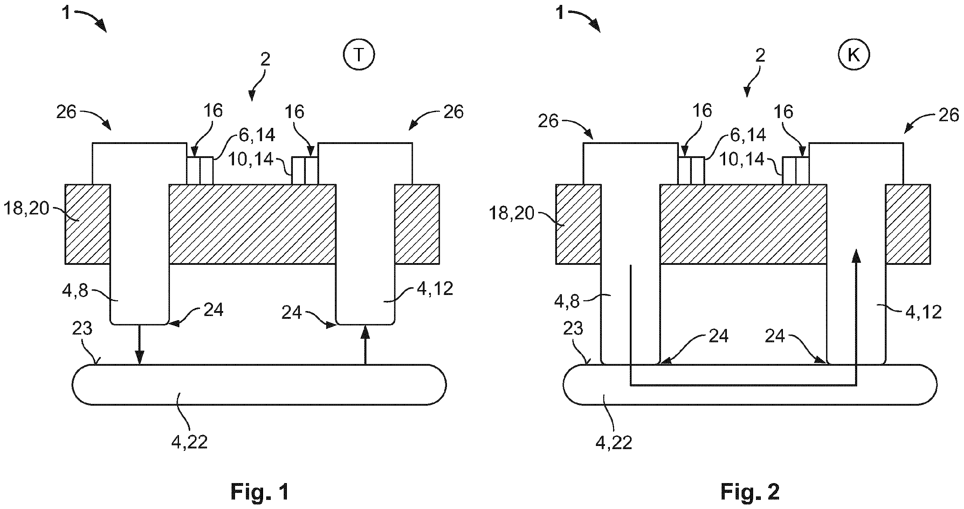

Figures 1 and 2 show a first exemplary embodiment of a contact arrangement 1.

The contact arrangement 1 includes a measuring device 2 for detecting a contacting state of the contact arrangement 1 and at least two electrical contacts 4, which are electrically isolated from one another in a first, open contacting state T (see Fig. 1) and are electrically connected to one another in a second, closed contacting state K (see Fig. 2). The measuring device 2 comprises an acoustic signal transmitter 6, which is adapted to couple an acoustic signal, in particular a sound wave, into a first contact 8 of the at least two contacts 4, and a signal receiver 10, which is connected to a second contact 12 of the at least two contacts 4 in a sound-conducting manner.

By coupling the signal transmitter 6 and the signal receiver 10 at different contacts of the contact arrangement, the sound wave can be transmitted directly via the contacts. The acoustic signal is conducted from the signal transmitter to the signal receiver via the structure-borne sound via the contacts of the contact arrangement. Since the acoustic signal, in contrast to a magnetic or electrical signal, is independent of the type and level of voltage, failures caused, for example, by light bridges, short circuits and/or welding can be reliably detected. Furthermore, the measuring device 2 and the method can be used in different contact arrangements without undue effort.

The signal transmitter 6 and signal receiver 10 can be adapted to couple an acoustic signal in the ultrasonic range from about 16 kHz into the first contact 8 or to receive it from the second contact 12. For this purpose, signal transmitter 6 and signal receiver 10 can preferably be piezoelectric elements 14, with which a compact and low-wear measuring device 2 can be provided.

An electrical isolator 16, in particular a galvanic isolator, can be arranged between the signal transmitter 6 and the first contact 8 and between the signal receiver 10 and the second contact 12 to ensure reliable electrical isolation between the contacts and the signal transmitter or signal receiver. The electrical isolator 16 may, for example, be made of a ceramic material comprising at least a similar sound conduction as the material of the electrical contacts 4. Consequently, the acoustic signal can be coupled from the signal transmitter 6 into the first contact 8 via the electrical isolator 16, or the acoustic signal can be received by the signal receiver 10 from the second contact 12 via the electrical isolator 16, without any major fluctuations in its parameters.

As can be seen in Figures 1 and 2, first contact 8 and second contact 12 may be held stationary in the contact arrangement 1. The first and second contacts 8, 12 may be held on a common carrier 18, for example a housing wall. The carrier 18 may serve as a damping element 20, which has a lower acoustic conductivity than the material of the contacts 4. Thus, in the open state T, the acoustic signal may be transmitted between the first and second contacts 8, 12 via the damping element 20, thereby verifying that the measuring device 2 is ready for operation.

For opening or closing the electrical contacts 4, in particular the first and second contacts 8, 12, a further electrical contact 4 serving as a bridging contact 22 can be provided. The bridging contact 22 can be held movably relative to the first and second contacts 8, 12, wherein the bridging contact 22 comprises an abutment surface 23 facing the respective first and second contacts 8, 12, which abutment surface is spaced apart from at least one of the first and second contacts 8, 12 in the open contacting state T and abuts a respective contacting end 24 of the first and second contacts 8, 12 in the closed contacting state K. Consequently, not only is transmission of the electric current via the bridging contact 22 ensured, but also transmission of the structure-borne sound.

If the first and second contacts 8, 12 are connected to each other, a continuous path for the propagation of the structure-borne sound from the signal transmitter to the signal receiver is ensured. Therefore, in the closed contacting state K, the sound wave can be conducted from the signal transmitter 6 to the signal receiver 10 with the least resistance. However, if the closed contacting state K is dissolved by moving the bridging contact 22 away from at least one of the first and second contacts 8, 12, an air bridge is generated between the contacting end 24 and the abutment surface 23, which has a damping effect on the sound wave, particularly in the ultrasonic range. Furthermore, the distance the sound wave has to travel to get from the signal transmitter to the signal receiver is increased.

Signal transmitter 6 and/or signal receiver 10 can preferably be arranged at an end 26 of the respective contact 8, 12 facing away from the contacting end 24 so that the acoustic signal propagates directionally over the entire contact and measurement errors can be avoided.

Of course, the contact arrangement 1 may also comprise two contacts which are movable relative to each other and which directly abut against each other in the closed contacting state K.

The contact arrangement 1 can be part of an electrical switching device 27.

Furthermore, a retrofit kit may comprise a measuring device 2 which can be integrated in a contact arrangement comprising at least two contacts.

The measuring device 2 may be adapted to output a representative signal for at least one of the following parameters: running time; sound pressure; sound energy; and sound intensity.

According to this exemplary configuration, the measuring device 2 may be adapted to output a measurement signal representative of the acoustic intensity and a measurement signal representative of the running time of the acoustic signal.

Since the sound intensity can be dampened by air or a contact-inhibiting layer of dirt located between the abutment surface 23 and the contacting end 24, it is possible to reflect whether or not electrical contacting is taking place by considering the measurement signal representative of the sound intensity.

The measurement of the running time of the acoustic signal can in particular be related to the zero crossings, i.e. the phase change, of the acoustic signal. Consequently, the zero crossing of the acoustic signal at the signal transmitter 6 is considered the starting point and the zero crossing of the acoustic signal at the signal receiver 10 is considered the end point. This is preferred because the phase change of the acoustic signal is less influenced by disturbances, for example, sound reflection, in contrast to the other sound parameters. Since the running time of the acoustic signal is proportional to the travel path of the acoustic signal, the distance between the contacts 4, which are adapted to abut directly against each other, can be determined when considering the measurement signal representative of the running time.

By combining the two measurement signals, failures can be avoided or at least detected. For example, the onset of levitation can be detected at high short-circuit currents, which can cause arcing resulting in two contacts welding together.

The measurement can preferably take place continuously so that changes in the contacting state can be registered at any time. However, if continuous operation of the measuring device is to be avoided, the measurement can also take place in a pulsed manner, for example as a function of a switching signal.

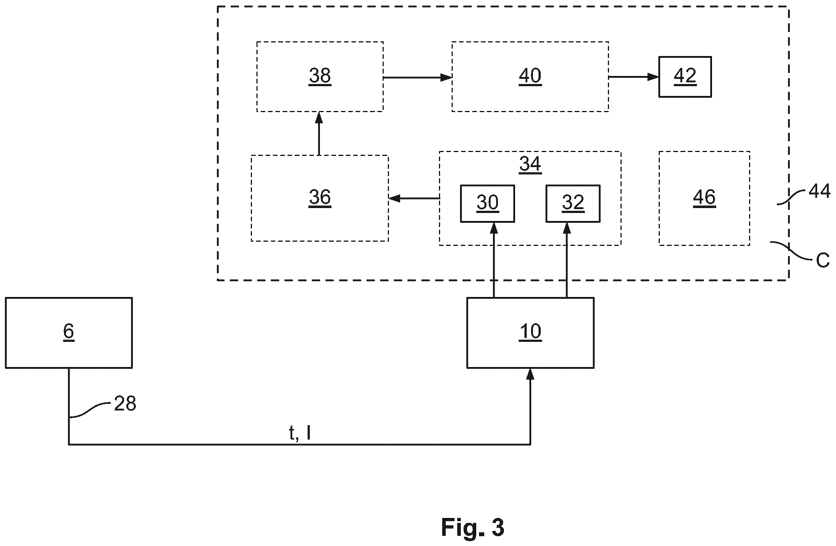

Fig. 3 shows a schematic sketch of a block diagram of an exemplary configuration of a measuring device.

In the computer-implemented method, at least one of the two measurement signals can be read out and the contacting state of the contact arrangement can be determined on the basis of its measurement parameter.

The block diagram shows the signal transmitter 6, which couples the acoustic signal 28 into the first contact, and the signal receiver 10, which receives the acoustic signal 28 with a sound intensity I and after a running time t. Based on the acoustic signal 28 received by the signal receiver 10, a measurement signal 30 representative of the sound intensity I of the acoustic signal 28 and a measurement signal 32 representative of the running time t of the acoustic signal 28 can be output.

These measurement signals 30, 32 can be stored on a storage unit 34. The storage unit 34 can be integrated in a computer system C or at least can be read out by a computer system C. For this purpose, the computer system C may have a readout unit 36 which can access the measurement signals 30, 32 stored on the storage unit 34.

The read out measurement signals 30, 32 can be evaluated via an evaluation unit 38 and the corresponding contacting state can be determined. The evaluation unit 38 can be coupled to an output unit 40 which outputs the contacting state and/or the distance between two contacts which abut against each other at least in the closed contacting state on the basis of an output value 42.

In particular, the computer system C may be a data processing system and comprise a processor 44 configured such that it executes the computer-implemented method.

Commands for executing the method may be stored on a computer-readable storage medium 46, for example, the commands causing the computer system C to execute the method.

The computer system can be integrated in the contact arrangement or decoupled from it. If the computer system C is decoupled from the contact arrangement, a connection can be provided via which the measurement signals can be accessed.

The computer system may also include a command unit (not shown) that may be coupled to the signal transmitter 6 and may cause the signal transmitter to couple the acoustic signal into the first contact 8.

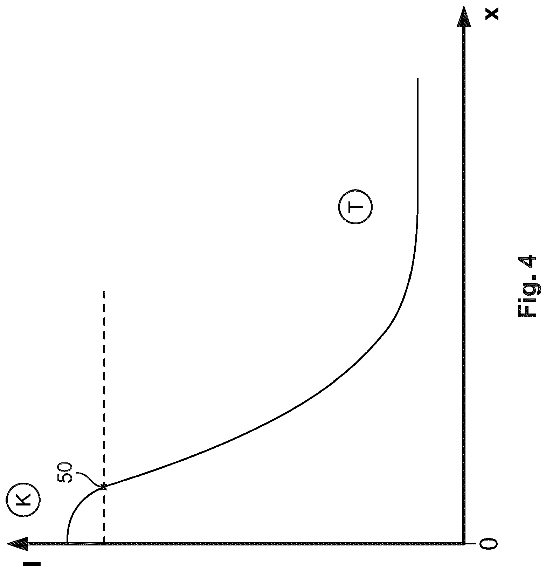

Fig. 4 shows an exemplary sketch of a diagram showing the course of the sound intensity as a function of the contacting distance.

In the diagram, the sound intensity I is on the ordinate and the distance x of the contacts to be contacted is on the abscissa.

At a contact distance of 0, i.e. when the contacts abut each other, the sound intensity of the acoustic signal at the signal receiver reaches its maximum. If the contacts are now moved away from each other, the sound intensity decreases continuously due to the air bridge between the contacts, wherein the contacting state is changed from closed K to open T when the value falls below a threshold value 50. The threshold value 50 is only schematically drawn in the diagram and can vary depending on the contact arrangement. The threshold value can, for example, be stored in the system by means of calibration and represent the value at which no current flow occurs between the contacts to be contacted. Consequently, for any value of sound intensity I above the threshold 50, an output value representative of the closed contacting state K can be output.

In particular for an analysis of the exact distance between the contacts, the consideration of the sound intensity is less suitable, since this is exposed to additional fluctuations by the reflection and the like. If a statement about the exact distance between the contacts is to be made, a consideration of the running time is better suited, since this is exposed to smaller fluctuations in comparison to the remaining sound quantities and can be combined simply with the sound intensity.

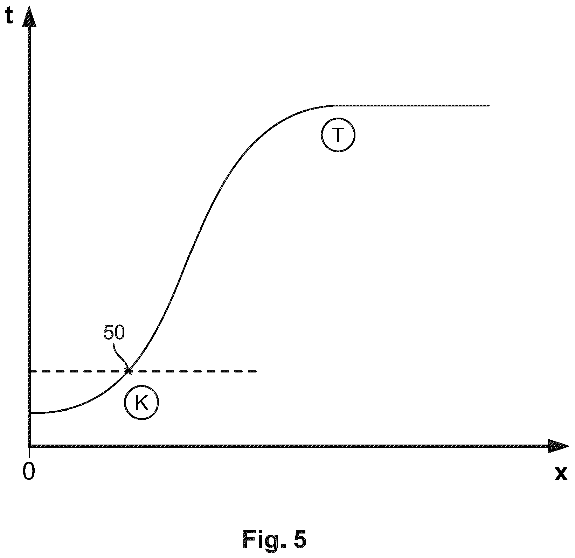

A diagram showing the course of the running time t as a function of the contacting distance x is shown in Fig. 5.

Here, too, a threshold value 50 can be specified, with any value below the threshold value 50 suggesting a closed contacting state K and any value above the threshold value 50 suggesting an open contacting state T.

### Reference Signs

- 1: contact arrangement
- 2: measuring device
- 4: electrical contact
- 6: signal transmitter
- 8: first electrical contact
- 10: signal receiver
- 12: second electrical contact
- 14: piezoelectric element
- 16: electrical isolator
- 18: carrier
- 20: damping element
- 22: bridging contact
- 23: abutment surface
- 24: contacting end
- 26: end facing away from the contacting end
- 27: electrical switching device
- 28: acoustic signal
- 30: measurement signal
- 32: measurement signal
- 34: storage unit
- 36: readout unit
- 38: evaluation unit
- 40: output unit
- 42: output value
- 44: processor
- 46: storage medium
- 50: threshold value
- C: computer system
- I: sound intensity
- K: closed contacting state
- T: open contacting state
- t: running time
- x: distance

## Claims

1. Contact arrangement (1) comprising a measuring device (2) for determining a contacting state of the contact arrangement (1) and at least two electrical contacts (4), which in a first, open contacting state (T) are electrically isolated from one another and in a second, closed contacting state (K) are electrically connected to one another, wherein the measuring device (2) comprises an acoustic signal transmitter (6), which is configured to couple an acoustic signal (28) into a first contact (8) of the at least two contacts (4), and a signal receiver (10), which is connected to a second contact (12) of the at least two contacts (4) in a sound-conducting manner.

2. Contact arrangement (1) according to claim 1, wherein the acoustic signal transmitter (6) is adapted to couple the acoustic signal (28) in the ultrasonic range.

3. Contact arrangement (1) according to claim 1 or 2, wherein the measuring device (2) is adapted to output a measurement signal (30, 32) representative of at least one of the following parameters of the acoustic signal (28):
- running time (t);
- sound pressure;
- sound energy; and
- sound intensity (I).

4. Contact arrangement (1) according to claim 3, wherein the measuring device (2) is adapted to output a first measurement signal (30) representative of the sound intensity (I) of the acoustic signal (28) and a second measurement signal (32) representative of the running time (t) of the acoustic signal (28).

5. Contact arrangement (1) according to one of claims 1 to 4, wherein an electrically isolating damping element (20) extending between the at least two contacts (4) is arranged at least in the open contacting state (T).

6. Contact arrangement (1) according to one of claims 1 to 5, wherein the contact arrangement (1) comprises a bridge contact (22) which is movable relative to the first and/or second contact (8, 12) and via which the first and second contacts (8, 12) are electrically connected to one another in the closed contacting state (K).

7. Contact arrangement (1) according to one of claims 1 to 6, wherein signal transmitter (6) and/or signal receiver (10) is arranged at an end (26) of the respective contact (8, 12) arranged opposite a contacting end (24).

8. Method for measuring a contacting state in a contact arrangement (1) comprising at least two electrical contacts (4) which are electrically isolated from each other in a first, open, contacting state (T) and electrically connected to each other in a second, closed, contacting state (K), comprising the following steps:
- coupling an acoustic signal (28) into a first electrical contact (8) of the at least two electrical contacts (4); and
- receiving the acoustic signal (28) at a second electrical contact (12) of the at least two electrical contacts (4).

9. Method according to claim 8, wherein an acoustic signal (28) is continuously coupled into the first electrical contact (8).

10. Method according to claim 8, wherein the acoustic signal (28) is coupled into the first electrical contact (8) in response to a switching signal.

11. Computer-implemented method comprising the steps of:
- reading out a measurement signal (30, 32) from a measuring device (2), the measurement signal being representative of an acoustic signal (28) transmitted from one electrical contact (4) of a contact arrangement (1) to another contact (4) of the contact arrangement (1), wherein the measurement signal (30, 32) includes at least one measurement parameter representative of at least one of the following parameters of the acoustic signal (28):
- running time (t);
- sound pressure;
- sound energy; and
- sound intensity (I);
- determining a contacting state (K, T) of the contact arrangement (1) by means of the at least one measurement parameter.

12. System for processing data (C) comprising a processor (44) configured such that it executes the method according to claim 11.

13. Computer-readable storage medium (46) comprising commands which, when executed by a computer, cause the computer to execute the method according to claim 11.

14. Electrical switching device (27) comprising a contact arrangement (1) according to one of claims 1 to 7.

15. Using a measuring device (2) having an acoustic signal transmitter (6) adapted to couple a sound wave (28) into a first electrical contact (8) of said at least two electrical contacts (4), and a signal receiver (10) adapted to be connected to a second electrical contact (12) of said at least two electrical contacts (4) in a sound conducting manner with a contact arrangement (1) comprising at least two electrical contacts (4) which, in a first, open contacting state (T), are electrically isolated from one another and, in a second, closed contacting state (K), are electrically connected to one another.

## Patentansprüche

1. Kontaktanordnung (1) mit einer Messeinrichtung (2) zur Bestimmung eines Kontaktierungszustandes der Kontaktanordnung (1) und mindestens zwei elektrischen Kontakten (4), die in einem ersten, offenen Kontaktierungszustand (T) elektrisch voneinander getrennt und in einem zweiten, geschlossenen Kontaktierungszustand (K) elektrisch miteinander verbunden sind, wobei die Messeinrichtung (2) einen akustischen Signalgeber (6), der zum Einkoppeln eines akustischen Signals (28) in einen ersten Kontakt (8) der mindestens zwei Kontakte (4) ausgebildet ist, und einen Signalempfänger (10), der mit einem zweiten Kontakt (12) der mindestens zwei Kontakte (4) schallleitend verbunden ist, umfasst.

2. Kontaktanordnung (1) nach Anspruch 1, wobei der akustische Signalgeber (6) zur Einkopplung des akustischen Signals (28) im Ultraschallbereich ausgebildet ist.

3. Kontaktanordnung (1) nach Anspruch 1 oder 2, wobei die Messeinrichtung (2) ausgebildet ist, ein Messsignal (30, 32) auszugeben, das für mindestens einen der folgenden Parameter des akustischen Signals (28) repräsentativ ist:
- Laufzeit (t);
- Schalldruck;
- Schallenergie; und
- Schallintensität (I).

4. Kontaktanordnung (1) nach Anspruch 3, wobei die Messvorrichtung (2) dazu ausgelegt ist, ein erstes Messsignal (30), das die Schallintensität (I) des akustischen Signals (28) darstellt, und ein zweites Messsignal (32), das die Laufzeit (t) des akustischen Signals (28) darstellt, auszugeben.

5. Kontaktanordnung (1) nach einem der Ansprüche 1 bis 4, wobei zumindest im offenen Kontaktierungszustand (T) ein sich zwischen den mindestens zwei Kontakten (4) erstreckendes elektrisch isolierendes Dämpfungselement (20) angeordnet ist.

6. Kontaktanordnung (1) nach einem der Ansprüche 1 bis 5, wobei die Kontaktanordnung (1) einen relativ zu dem ersten und/oder zweiten Kontakt (8, 12) beweglichen Brückenkontakt (22) aufweist, über den der erste und zweite Kontakt (8, 12) im geschlossenen Kontaktierungszustand (K) elektrisch miteinander verbunden sind.

7. Kontaktanordnung (1) nach einem der Ansprüche 1 bis 6, wobei an einem Kontaktierungsende (24) gegenüberliegenden Ende (26) des jeweiligen Kontakts (8, 12) ein Signalgeber (6) und/oder Signalempfänger (10) angeordnet ist.

8. Verfahren zur Messung eines Kontaktierungszustandes bei einer Kontaktanordnung (1) mit mindestens zwei elektrischen Kontakten (4), die in einem ersten, offenen Kontaktierungszustand (T) voneinander elektrisch isoliert und in einem zweiten, geschlossenen Kontaktierungszustand (K) elektrisch miteinander verbunden sind, mit folgenden Schritten:
- Einkoppeln eines akustischen Signals (28) in einen ersten elektrischen Kontakt (8) der mindestens zwei elektrischen Kontakte (4); und
- Empfangen des akustischen Signals (28) an einem zweiten elektrischen Kontakt (12) der mindestens zwei elektrischen Kontakte (4).

9. Verfahren nach Anspruch 8, wobei ein akustisches Signal (28) kontinuierlich in den ersten elektrischen Kontakt (8) eingekoppelt wird.

10. Verfahren nach Anspruch 8, wobei das akustische Signal (28) in den ersten elektrischen Kontakt (8) in Reaktion auf ein Schaltsignal eingekoppelt wird.

11. Computer-implementiertes Verfahren mit den Schritten:
- Auslesen eines Messsignals (30, 32) aus einer Messvorrichtung (2), wobei das Messsignal repräsentativ für ein akustisches Signal (28) ist, das von einem elektrischen Kontakt (4) einer Kontaktanordnung (1) zu einem anderen Kontakt (4) der Kontaktanordnung (1) übertragen wird, wobei das Messsignal (30, 32) mindestens einen Messparameter enthält, der repräsentativ für mindestens einen der folgenden Parameter des akustischen Signals (28) ist:
- Laufzeit (t);
- Schalldruck;
- Schallenergie; und
- Schallintensität (I);
- Bestimmen eines Kontaktierungszustandes (K, T) der Kontaktanordnung (1) mittels des mindestens einen Messparameters.

12. System zur Datenverarbeitung (C) mit einem Prozessor (44), der so konfiguriert ist, dass er das Verfahren nach Anspruch 11 ausführt.

13. Computerlesbares Speichermedium (46) mit Befehlen, die, wenn sie von einem Computer ausgeführt werden, den Computer veranlassen, das Verfahren nach Anspruch 11 auszuführen.

14. Elektrisches Schaltgerät (27) mit einer Kontaktanordnung (1) nach einem der Ansprüche 1 bis 7.

15. Verwendung einer Messeinrichtung (2) mit einem akustischen Signalgeber (6), der zum Einkoppeln einer Schallwelle (28) in einen ersten elektrischen Kontakt (8) der mindestens zwei elektrischen Kontakte (4) eingerichtet ist, und einem Signalempfänger (10), der mit einem zweiten elektrischen Kontakt (12) der mindestens zwei elektrischen Kontakte (4) schallleitend verbindbar ist, mit einer Kontaktanordnung (1) aus mindestens zwei elektrischen Kontakten (4), die in einem ersten, offenen Kontaktierungszustand (T) elektrisch voneinander isoliert und in einem zweiten, geschlossenen Kontaktierungszustand (K) elektrisch miteinander verbunden sind.

## Revendications

1. Agencement de contacts (1) comprenant un dispositif de mesure (2) permettant de déterminer l'état de contact de l'agencement de contacts (1) et au moins deux contacts électriques (4), qui, dans un premier état de contact ouvert (T) sont isolés électriquement l'un de l'autre et dans un second état de contact fermé (K) sont reliés électriquement l'un à l'autre, le dispositif de mesure (2) comprenant un émetteur de signal acoustique (6) qui est configuré pour coupler un signal acoustique (28) dans un premier contact (8) faisant partie des deux contacts (4) ou plus et un récepteur de signal (10) qui est connecté à un second contact (12) faisant partie des deux contacts (4) ou plus afin de faire conduire le son.

2. Agencement de contacts (1) selon la revendication 1, dans lequel l'émetteur de signal acoustique (6) est conçu pour coupler le signal acoustique (28) dans la plage des ultrasons.

3. Agencement de contacts (1) selon la revendication 1 ou la revendication 2, dans lequel le dispositif de mesure (2) est conçu pour délivrer en sortie un signal de mesure (30, 32) représentatif d'au moins l'un des paramètres suivants du signal acoustique (28) :
- le temps de fonctionnement (t),
- la pression sonore,
- l'énergie sonore, et
- l'intensité du son (I).

4. Agencement de contacts (1) selon la revendication 3, dans lequel le dispositif de mesure (2) est conçu pour délivrer en sortie un premier signal de mesure (30) représentatif de l'intensité du son (I) du signal acoustique (28) et un second signal de mesure (32) représentatif du temps de fonctionnement (t) du signal acoustique (28).

5. Agencement de contacts (1) selon l'une des revendications 1 à 4, dans lequel un élément d'amortissement isolant électriquement (20) s'étendant entre les deux contacts (4) ou plus est disposé au moins dans l'état de contact ouvert (T).

6. Agencement de contacts (1) selon l'une des revendications 1 à 5, où l'agencement de contacts (1) comprend un contact formant pont (22) qui est mobile par rapport au premier et/ou au second contact (8, 12) et au travers duquel les premier et second contacts (8, 12) sont reliés électriquement l'un à l'autre dans l'état de contact fermé (K).

7. Agencement de contacts (1) selon l'une des revendications 1 à 6, dans lequel l'émetteur de signal (6) et/ou le récepteur de signal (10) sont agencés à une extrémité (26) du contact respectif (8, 12) placé à l'opposé d'une terminaison de contact (24).

8. Procédé de mesure de l'état de contact dans un agencement de contacts (1) comprenant au moins deux contacts électriques (4) qui sont isolés électriquement l'un de l'autre dans un premier état de contact ouvert (T) et qui sont reliés électriquement l'un à l'autre dans un second état de contact fermé (K), comprenant les étapes suivantes :
- le couplage d'un signal acoustique (28) dans un premier contact électrique (8) parmi les deux contacts électriques (4) ou plus, et
- la réception du signal acoustique (28) au niveau d'un second contact électrique (12) parmi les deux contacts (4) ou plus.

9. Procédé selon la revendication 8, dans lequel un signal acoustique (28) est couplé de manière continue dans le premier contact électrique (8).

10. Procédé selon la revendication 8, dans lequel le signal acoustique (28) est couplé dans le premier contact électrique (8) en réponse à un signal de commutation.

11. Procédé implémenté sur ordinateur comprenant les étapes suivantes :
- la lecture d'un signal de mesure (30, 32) provenant d'un dispositif de mesure (2), le signal de mesure étant représentatif d'un signal acoustique (28) transmis depuis un premier contact électrique (4) d'un agencement de contacts (1) jusqu'à un autre contact (4) de l'agencement de contacts (1), le signal de mesure (30, 32) incluant au moins un paramètre de mesure représentatif d'au moins l'un des paramètres suivants du signal acoustique (28) :
- le temps de fonctionnement (t),
- la pression sonore,
- l'énergie sonore, et
- l'intensité du son (I),
- la détermination de l'état de contact (K, T) de l'agencement de contacts (1) au moyen du ou des paramètres de mesure.

12. Système de traitement de données (C) comprenant un processeur (44) configuré de sorte à exécuter le procédé conforme à la revendication 11.

13. Support de stockage pouvant être lu par ordinateur (46) comprenant des instructions qui, lorsqu'elles sont exécutées par un ordinateur, amènent l'ordinateur à exécuter le procédé conforme à la revendication 11.

14. Dispositif de commutation électrique (27) comprenant un agencement de contacts (1) conforme à l'une des revendications 1 à 7.

15. Utilisation d'un dispositif de mesure (2) comportant un émetteur de signal acoustique (6) conçu pour coupler une onde sonore (28) dans un premier contact électrique (8) faisant partie desdits deux contacts (4) ou plus, ainsi qu'un récepteur de signal (10) conçu pour être connecté à un second contact électrique (12) faisant partie desdits deux contacts (4) ou plus de façon à faire conduire le son avec un agencement de contacts (1) comprenant au moins deux contacts électriques (4) qui, dans un premier état de contact ouvert (T) sont isolés électriquement l'un de l'autre et dans un second état de contact fermé (K) sont reliés électriquement l'un à l'autre.
